# EUROPÄISCHE PATENTANMELDUNG

(11) **EP 0 535 414 A2**
(43) Veröffentlichungstag der Anmeldung: **07.04.1993**
(21) Anmeldenummer: 92115455.5
(22) Anmeldetag: 10.09.1992
(51) Int. Cl.: H01L 23/48, H01L 23/373, H01L 23/495

(54) **Elektronische Schaltungsanordnung**

(30) Priorität: 04.10.1991 DE 4132947
(71) Anmelder: EXPORT-CONTOR Aussenhandelsgesellschaft mbH, D-90253 Nürnberg (DE)
(72) Erfinder: Göbl, Christian, W-8500 Nürnberg 70 (DE); Löwer, Dieter, W-8540 Schwabach (DE)

(57) **Zusammenfassung**

Es wird eine elektronische Schaltungsanordnung beschrieben, die in ihrem Aufbau neue Bauteile integriert.
Bekannte Schaltungsanordnungen sind durch den Einsatz von Metalloxid-Keramiken zur Isolation gegenüber der Kühlfläche in ihrer Packungsdichte begrenzt. Die bekannt konventionelle Verdrahtungstechnik engt die Packungsdichte weiter ein. Durch den Einsatz von wärmeleitenden elektrisch isolierenden und/oder leitenden Pasten (14,30) sowie von flexiblen Leiterplatten (16,28), die an sich bekannt sind, auch in dem Sektor der Hochleistungs-Schaltungsanordnungen ist es möglich, die Packungsdichte der Bauelemente (22,32) zu erhöhen, die Verbindungstechnik (16,26,28) wesentlich zu rationalisieren und die Kontaktierung zu optimieren. Die wirtschaftliche Fertigung, verbunden mit zerstörungsfreier partieller Demontagemöglichkeit, bei Verwendung von Pasten und Folien gestattet den weitergehenden Zusammenbau von elektronischen Schaltungsanordnungen mit umfangreicherem Schaltungsinhalt in einer Schaltungseinheit.

## Beschreibung

Die Erfindung betrifft eine elektronische Schaltungsanordnung nach dem Oberbegriff des Anspruches 1.

Es ist bekannt, daß beim Aufbau insbesondere von Leistungs-Halbleiter-Bauelemente-Chips zu diskreten Bauelementen aber in noch stärkerem Maße zu integrierten Bauelementen erhöhte Aufmerksamkeit auf das Abführen der sich beim Betrieb im Einsatzfall bildenden Wärmemengen zu legen ist. Dieses Problem setzt hauptsächlich die Grenzen der oberen Leistungsfähigkeit und Dimensionierung. Diese Grenzen zu erweitern ist Gegenstand des Bemühens bei der Konzipierung neuer elektronischer Schaltungsanordnungen.

Die Wärmeübergänge zu entsprechenden Kühlflächen sind folglichneben der zuverlässigen dauer- und wechselbelastbaren elektrischen Verbindung mit besonderer Sorgfalt bei der konstruktiven Gestaltung der Bauelemente zu berücksichtigen. Bei immer weiterer Integration von Chips in ein einziges Schaltungselement sind die Wärmeübergänge auf die Kühlflächen ausschlaggebend für die funktionssichere Lebensdauer.

In diesem Bestreben ist ein wechsellastbeständiges schaltbares Leistungs-Halbleiter-Bauelement in der Vormontage seines Chips zu einem druckkontaktbelastbaren "Sandwich" aus der DE-PS 34 21 672 nennenswert. Dieses Bauelement bietet beim druckkontaktierten Aufbau einen niedrigen Wärmewi-derstand und besitzt somit die Voraussetzungen für eine hohe Strombelastbarkeit für Wechselbelastungen bei guter Langzeitstabilität.

Die technologisch sinnvolle Kombination von form- und stoffschlüssiger Verbindungstechnik der für den Aufbau von elektronischen Schaltungsanordnungen benötigten Einzelbauteile ist aus der Literatur bekannt. So beschreibt DE-PS 36 28 556 eine Halbleiteranordnung, bei der Stromleiterteile wenigstens teilweise zur Druckkontaktierung ausgebildet sind, da hier eine wirtschaftliche Möglichkeit des Auswechselns einzelner Schaltungsteile gegeben ist, wie das auch bei Bauelementen nach DE-PS 30 05 313 möglich ist.

Auch in DE-PS 35 08 456 wird ein druckkontaktiertes Leistungs-Halbleiter-Bauelement beschrieben, hier, wie auch in den vorgenannten Schriften, wird d elektrische Isolation gegenüber dem äußeren Kühlbauteil über Metalloxidkeramiken erreicht.

Stoffschlüssige Verbindungen der einzelnen Bauteile einer elektronischen Anordnung untereinander, insbesondere das hauptsächlich geübte Löten, haben eine obere Grenze der Anwendbarkeit bezüglich der Größe der gelöteten Fläche, wie das bereits in DE-PS 37 36 671 festgestellt wird. Die unterschiedlichen Ausdehnungskoeffizienten der Bauteile untereinander und zu der eingesetzten Metalloxid-Keramik als Isolatorschicht führt zur Verwölbung mit hohen Scherkräften an den Verbindungsstellen insbesondere bei wechselnden Temperaturen.

Der Erfindung liegt die Aufgabe zugrunde, ein Leistungs-Halbleiter-Bauelement ohne den Einsatz von Metall-Oxid-Keramiken zu formulieren und dabei die Isolation der stromführenden Bauteile gegenüber dem Kühlbauteil bei guter Wärmeleitfähigkeit sicherzustellen, die elektrischen Verbindungsteile in der Menge zu reduzieren, eine höhere Integrationsdichte in den elektronischen Schaltungsanordnungen zu ermöglichen und die Vorteile der form- und stoffschlüssigen Verbindungstechniken auf einfache Art auch kombiniert zu nutzen.

Die Lösung der Aufgabe besteht bei einer solchen elektronischen Schaltungsanordnung der eingangs genannten Art in den kennzeichnenden Merkmalen des Anspruches 1. Vorteilhafte Weiterbildungen sind in den Merkmalen der Ansprüche 2 bis 13 gegeben.

Anhand der in den Figuren 1 bis 5 vergrößert dargestellten Skizzen einzelner Schnitte von Teilansichten möglicher Schaltungsanordnungen wird der Gegenstand der Erfindung erläutert.
Fig. 1 zeigt einen Schaltungsausschnitt, in dem der erfindungsgemäße Isolationsaufbau mit bekannten Verbindungstechniken kombiniert ist.
Fig. 2 zeigt eine Einzelheit der Schichtfolge zwischen dem Kühlbauteil und Leistungs-Halbleiter-Bauelement in stoffschlüssiger Aufbauart.
Fig. 3 veranschaulicht den Aufbau eines Halbleiter-Chips in formschlüssiger Aufbauweise.
Fig. 4 stellt eine analoge Einzelheit mit druckkontaktiertem Verbindungselement dar und in
Fig. 5 ist der Einsatz einer zweiten flexiblen Leiterplatte als Einzelheit skizziert.
Gleiche Teile haben in allen Figuren die gleiche Benennung.

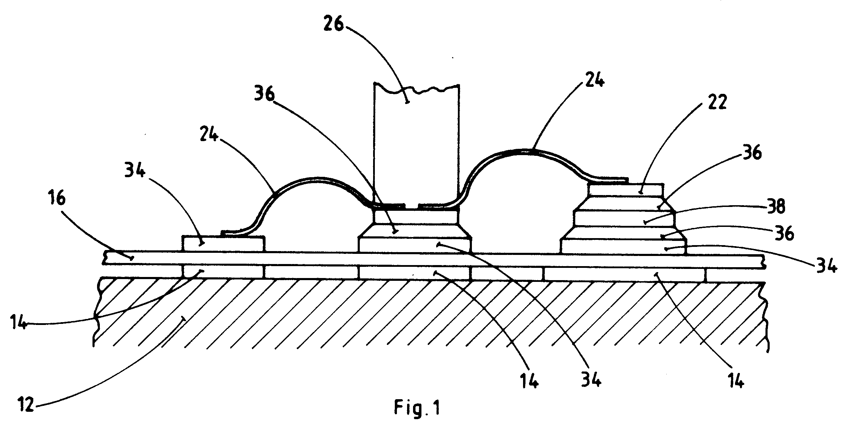

Die elektronische Schaltungsanordnung hat gemäß Fig. 1 den folgenden erfindungsgemäß relevanten Schichtaufbau: Auf einem Kühlbauteil(12), dessen Geometrie unbeachtlich bleiben soll, wird auf der für den Schaltungsaufbau vorgesehenen Fläche vorzugsweise im Siebdruckverfahren eine Paste (14) in durch das Sieb vorgegebenen Kontur und gleichmäßiger Dicke aufgetragen. Diese Paste (14) hat die Aufgabe, einen guten Übergang für die im Halbleiterkörper im Arbeitszustand entstehende Wärme zum Kühlbauteil (12) zu ermöglichen. Ein blasenfreier Auftrag der elektrisch isolierenden Paste (14) ist für die späteren guten Eigenschaften wichtig. Eine Verbesserung der Wärmeleitung kann bei der vorzugsweise aus organischen Esterölen hergestellten Paste durch Zumischen von pulverisierten Metalloxiden, vorzugsweise Zinkoxid, erzielt werde. Dabei ist der Anteil des Füllstoffes in Grenzen variierbar, wobei ein höherer Metalloxid-Anteil die Wärmeleitung fördert.

Die Paste (14) besitzt die Eigenschaft, auch bei den wiederholt auftretenden Betriebstemperaturen nahe dem erlaubten oberen Maximalpegel dauerplastisch zu bleiben, ohne "auszubluten", d.h. die Paste läuft auch bei Druckkontakten nicht von der Kontaktstelle in nicht unter Druck stehende Bereiche.

Auf diese strukturierte und pastöse Schicht (14) ist erfindungsgemäß eine flexible Folie (16) aus organischen Polymeren, vorzugsweise Polyimid- oder Ployesterfolie fixiert. Diese ansich bekannten Folien bilden in hevorragender Weise zusammen mit der pastösen Schicht die Isolationsschicht der darauf aufgebauten stromführenden Bauteile zu dem Kühlbauteil. Der Vorteil des Einsatzes einer solchen Folie (16) mit den Eigenschaften der Formstabilität und Wärmebeständigkeit liegt in deren Flexibilität in den für den Aufbau von elektronischen Schaltungsanordnungen kritischen Bereichen.

Gegenüber jeder starren Isolationsschicht, gleich ob aus anorganischen (Metalloxiden) oder organischen Verbundwerkstoffen (z.B. Epoxidharz-Glasgewebe) ist hier der Vorteil gegeben, daß eine ausdehnungsbedingte Verschiebung der Schichten untereinander auch bei vorher beauflagtem Druck spannungsfrei möglich ist.

Die ansich gegebenen schlechteren Wärmeübergangswerte der Folie können durch verschiedene Methoden gegenüber den guten Wärmeleitwerten von Keramiken ausgeglichen werden. Durch Zugabe von Füllstoffen vor dem Ausbilden der Folie kann die Spannungsfestigkeit, die bei diesen Folien wesentlich besser als bei Keramiken ist, aufrechterhalten werden,während die Wärmeleitfähigkeit erhöht wird. Die Folien dürfen wesentlich dünner als Keramiken gestaltet werden und es ist möglich, diese dünnere Schicht aus zwei oder mehreren Lagen mit dazwischenlaminierter vorzugsweise Kupferfolie einzusetzen. In bestimmten Fällen ist es letztlich auch möglich, eine Schichtfolge aus Folien mit dazwischenliegenden Pasteschichten zu bilden, wobei diese Pasten dann elektrisch leitende Metalle als Füllstoff aufweisen sollten, da dann der Wärmeleitwert besser als bei der Zumischung von Metalloxiden ist. Solcher Art gebildete flexible Mehrlagenfolien in der die Durchschlagsfestigkeit erfordernder Stärke sind in den Figuren nicht gesondert aufgeführt, sondern mit der summarischen Bezeichnung (16) benannt.

Im weiteren Aufbau ist in Fig. 1 eine Metallfläche (34) in Form von drei Inseln dargestellt. Diese Inseln des Schaltungsausschnittes sind räumlich betrachtet das Schaltungsbild der strukturierten Metallkaschierung, die wegen der vorzüglichen elektrischen und wärmeleitenden Eigenschaften vorzugsweise aus Kupfer besteht, das vor dem Einsatz in die elektronische Schaltungsanordnung, aber nach dem Laminieren auf die flexible Folie, in bekannter Weise schaltungsgerecht strukturiert wurde. Die Leiterzüge, Löt- und Bondinseln so wie die Positionsstellen für den späteren Druckkontakt ermöglichen im Zusammenwirken eine einfache und platzsparende Anordnung bei hohem Integrationsgrad der für die Schaltung erforderlichen Bauteile. Die Metallkaschierung kann in der Dicke, entsprechend der geforderten elektrischen Leistungsaufnahme, unterschiedlich definiert werden.

Der weitere Aufbau in Fig. 1 beinhaltet das stoffschlüssige Befestigen von Verbindungselementen (24) durch Bonden oder das direkte oder indirekte (über eine metallische Schicht, z.B. Molybdän (38)) Befestigen von Bauelementen (22) auf der Metallkaschierung (34). Das Bauelement (22) kann durch z.B. Bonden stoffschlüssig auf der dem Kühlbauteil (12) abgewnandten Seite mit Verbindungdelementen (24), die ihrerseits in gleicher Weise stoffschlüssig mit anderen stromleitenden Verbindungselementen (26) kontaktiert sind, verbunden werden.

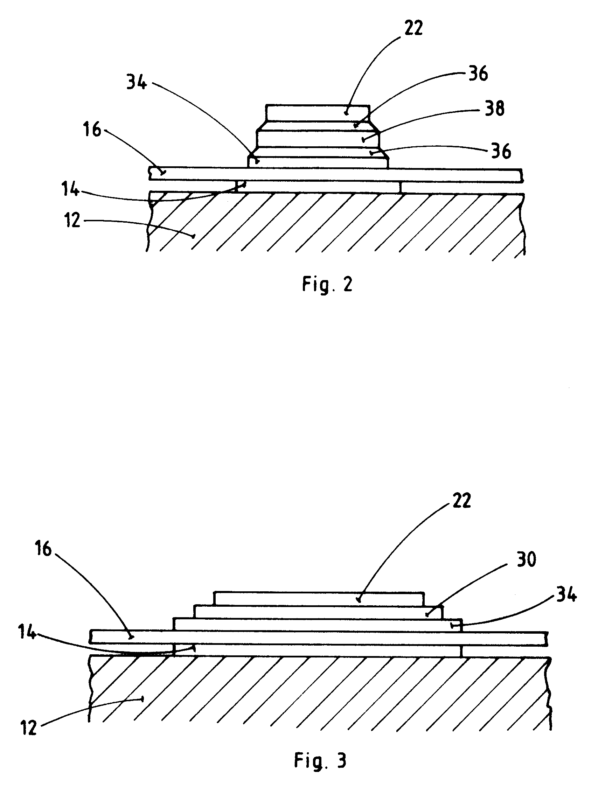

In Fig. 2 ist das Wesentliche des Schaltungsaufbaus mit stoffschlüssigen Verbindungen dargestellt. Das Leistungs-Halbleiter-Bauelement (22) ist auf z.B. Molybdän (38) gelötet (36). Das Molybdän wiederum ist auf die Lötfläche der strukturierten Metallkaschierung (34) der flexiblen Folie (16) gelötet (36). Damit ist ein guter Wärmeübergang vom Bauelement (22) zur z.B. Kupferschicht (34) der Folie (16) hergestellt. Die Folie (16) und die Paste (14) sorgen für den notwendigen guten Wärmeabfluß zum Kühlbauteil (12).

An geeigneten Stellen der elektronischen Schaltungsanordnung ist es möglich, den Aufbau nach Fig. 2 durch die Ausbildung von Druckkontakten zu vereinfachen. Das wird erfindungsgemäß dadurch realisiert, wie in Fig. 3 dargestellt, daß auf das Kühlbauteil (12) die Paste (14) und die Folie (16) mit der Metallkaschierung (34) in der bereits beschriebenen Weise aufgebaut wird. Auf die Kontaktfläche der Metallkaschierung (34) wird nun eine elektrisch leitende Paste (30) in geeigneter Weise punktuell oder flächenhaft gleichmäßig aufgetragen. Diese Paste (30) ist wie die früher beschriebene Paste (14) wärmeleitend, hat jedoch Metalle, wie beispielhaft Aluminium, Silber oder Kohlenstoff,in Form von Graphit, als Füllstoffbeimengung , so daß der schaltungsgerechte elektrische Stromfluß niederohmig oder praktisch widerstandslos von dem dort plazierten Bauelement (22) zu der Metalleiterbahn (34) der flexiblen Folie (16) möglich ist.

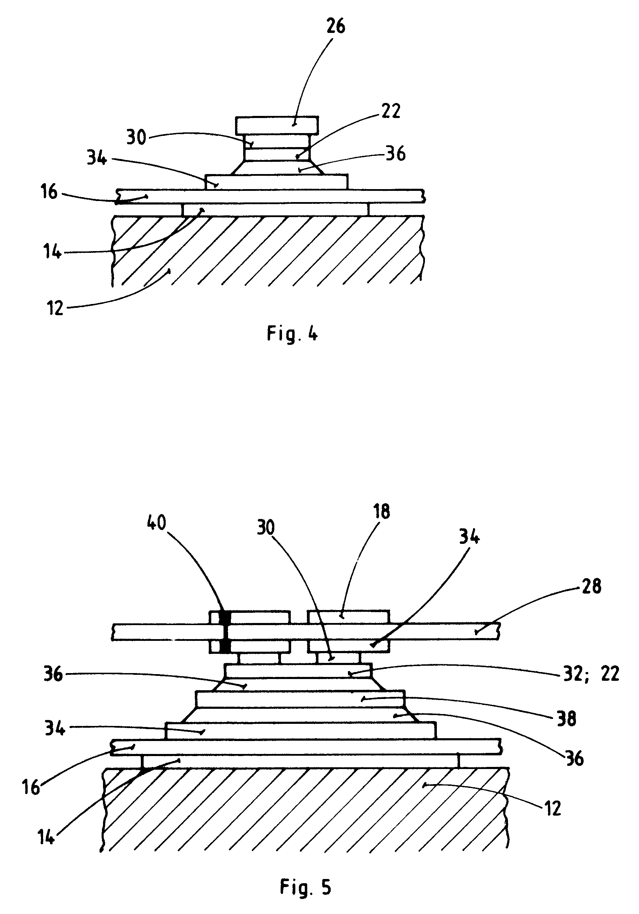

Eine erfindungsgemäße Schaltungsanordnung wird beispielhaft auch in dem Schaltungsausschnitt der Fig. 4 dargestellt. Auf dem Kühlbauteil (12) wird wiederum die Paste (14) und die Folie (16) positioniert. Die Folie (16) hat auch in dieser Darstellung mindestens eine Metallschicht zur Befestigung von Bauelementen auf einer Stromleitbahn (34). Hierauf ist stoffschlüssig (36) das Bauelement (22) befestigt. Die Kontaktierung der dem Kühlbauteil (12) abgewandten Seite des Bauelementes (22) wird mittels wärmeleitender Paste (30), die z.B. durch Silber als Füllstoff elektrisch leitend gestaltet wurde, zum Verbindungsteil (26) vorgenommen.

Fig. 5 skizziert einen Schaltungsausschnitt mit zwei eingesetzten flexiblen Folien. Dabei ist der Aufbau bis zum Halbleiterchip bereits im Zusammenhang mit der Beschreibung der Fig.1 bis 4 dargestellt. Speziell in den Einsatzfällen von Ansteuerbauelemente (32) mit geringer Strom- und folglich Wärmebelastung, aber auch bestimmte Leistungs-Halbleiter-Bauelemente (22) können über eine Leitpaste (30), wie bereits dargestellt wurde, auf der dem Kühlbauteil (12) abgewandten Seite direkt mit den Metalleitbahnen (34) einer zweiten flexiblen Folie (28) druckkontaktiert werden. Über Durchmetallisierungen (40) können so elektrische Verbindungen auf beiden Seiten der Folie (28) zur kreuzungsfreien Verdrahtung mit hoher Packungsdichte realisiert werden. Dabei ist es auch möglich, durch andere Dimensonierung der dargestellten oberen Metallkaschierung (18) die schaltungsgemäßen elektrischen Forderungen nach hoher Stromdichte zu erfüllen.

Durch den Einsatz dieser zweiten flexiblen Folie (28) ist es vorzüglich möglich, Ebenenunterschiede der einzelnen Aufbauinseln, wie sie durch den Zusammenbau der unterschiedlichsten Elemente der Schaltungsanordnung auftreten, auszugleichen. Weiterhin kann die Geometrie der oberen (28), aber auch der unteren Folie (16) durch Stanzen oder Fräsen so gestaltet werden, daß Aussparungen, Rundungen und Durchbrüche allen erdenklichen geometrischen Erfordernissen entsprechend eingearbeitet wurden und so für jede elektronische Schaltungsanordnung passgerechte Folien hergestellt werden können.

Der erfindungsgemäße Einsatz von flexiblen Leiterplatten in Leistungs-Halbleiter-Bauelementen eröffnet eine neue Dimension der Erhöhung der Packungsdichte, eine wirtschaftliche Großserienfertigung gepaart mit den Vorteilen der zerstörungsfreien Demontage von Teilbezirken der Schaltung und entsprechend wirtschaftlich vorteilhaftem Wiederaufbau bzw. Sekundärverwertung einzelner Schaltungselemente.

Die Löttechnik und Druckkontaktierung sind in dem Zusammenhang dieser Erfindung nicht beschrieben, es werden die dem Stand der Technik entsprechenden Verfahren und Methoden genutzt, um die elektronische Schaltungsanordnung zu komplettieren. Die Abschirmung und Hermetisierung war gleichfalls irrelevant im Zusammenhang mit der Darstellung des erfinderischen Gedankens.

## Patentansprüche

1. Elektronische Schaltungsanordnung mit einem Kühlbauteil (12), auf dem thermisch leitend und elektrisch isolierend ein Substratträger (16) aufgebracht ist, auf dem mindestens ein zu kühlendes Leistungs-Halbleiter-Bauelement (22) befestigt ist, das über Anschlußflächen zur elektrischen Verbindung mit den äußeren und schaltungsgerechten notwendigen internen Verbindungselementen (24,26) kontaktiert ist,
**dadurch gekennzeichnet, daß**
wärmeleitende Pasten (14,30) in definierter Dicke und Geometrie in dem Schichtaufbau vorgesehen sind und
formstabile und wärmebeständige flexible Folien (16,28), die aus organischen Polymeren hergestellt und auch mit strukturierten Metallkaschierungen versehen sind, sog. flexible Leiterplatten mit ein oder mehrschichtiger Folge , abwechselnd Folie und Metall, auch mit metallischen Verbindungen zwischen zwei oder mehreren Schichten über metallisierte Durchbrüche, als Substratträger (16) und/oder Verbindungselemente (28) eingebaut sind.

2. Elektronische Schaltungsanordnung nach Anspruch 1, dadurch gekennzeichnet, daß die wärmeleitende Paste (14) eine Schicht aus einem Gemisch geeigneter organischer Verbindungen mit einem definierten Anteil von Füllstoffen ist, die gleichzeitig ein guter elektrischer Isolator ist.

3. Elektronische Schaltungsanordnung nach Anspruch 2, dadurch gekennzeichnet, daß die Paste (14) auf Esterölbasis, mit Metalloxiden als Füllstoff, hergestellt ist.

4. Elektronische Schaltungsanordnung nach Anspruch 1, dadurch gekennzeichnet, daß die wärmeleitende Paste (30) aus einem Gemisch geeigneter organischer Verbindungen mit einem definierten Anteil von Füllstoffen aus Materialien, die den elektrischen Strom auch im Gemisch mit der organischen Trägersubstanz leiten, besteht.

5. Elektronische Schaltungsanordnung nach Anspruch 1 und 4, dadurch gekennzeichnet, daß die wärme- und elektrisch leitende Paste (30) an solchen Stellen positioniert ist, die über Druckkontakt eine galvanische Verbindung der entsprechenden Bauteile untereinander schaltungsgerecht realisieren.

6. Elektronische Schaltungsanordnung nach Anspruch 1, dadurch gekennzeichnet, daß der Substratträger (16) und/oder das Verbindungselement (28) aus Polyimid oder Polyester in Form flexibler Folien besteht, die ein- oder mehrlagig metallisiert und teilweise schaltungsgerecht strukturiert sind.

7. Elektronische Schaltungsanordnung nach Anspruch 1 und 6, dadurch gekennzeichnet, daß die auf den flexiblen Folien vorhandenen teilweise strukturierten Metallschichten aus Kupfer, auch mit partiellen Silber- oder Goldüberzügen, bestehen und in unterschiedlich definierten Schichtdicken, entsprechend der elektrischen Erfordernisse, ausgebildet sind.

8. Elektronische Schaltungsanordnung nach Anspruch 7, dadurch gekennzeichnet, daß die Leiterzüge der strukturierten Metallkaschierung der Folien so geformt sind, daß eine formschlüssige Verbindung direkt zu äußeren Stromanschlüssen möglich ist.

9. Elektronische Schaltungsanordnung nach Anspruch 7, dadurch gekennzeichnet, daß Kontaktinseln in der Metallstruktur der Folien vorhanden sind, auf welchen stoff- und/oder formschlüssig Verbindungselemente und/oder andere Bauteile sowie Bauelemente (22,32) kontaktiert werden.

10. Elektronische Schaltungsanordnung nach Anspruch 9, dadurch gekennzeichnet, daß durch Löten (36) oder Bonden (24) stoffschlüssige Verbindungen zwischen der Metallisierung der Folie (34) und einem Verbindungselement (26) oder einem Bauelement (22) direkt mit desssen Kontaktfläche oder indirekt über eine metallische Zwischenschicht (38) bestehen.

11. Elektronische Schaltungsanordnung nach Anspruch 9, dadurch gekennzeichnet, daß Druckkontakte direkt zwischen Metallisierungsschicht der Folie und Verbindungselement (26) oder Bauelement (22,32) oder indirekt über eine elektrisch leitende Paste (30) aufgebaut wurden.

12. Elektronische Schaltungsanordnung nach Anspruch 9, dadurch gekennzeichnet, daß einzelne Bauelemente (32) beidseitig mit flexiblen Leiterplatten (16,28) kontaktiert werden.

13. Elektronische Schaltungsanordnung nach Anspruch 10, dadurch gekennzeichnet, daß die metallische Zwischenschicht (38) aus Molybdän geformt ist und einen geeigneten galvanisch oder stromlos gebildeten Metallüberzug besitzt.
